# FASCICULE DE BREVET EUROPEEN

(11) **EP 3 179 629 B1**
(45) Date de publication et mention de la délivrance du brevet: **19.06.2019**
(21) Numéro de dépôt: 16202310.5
(22) Date de dépôt: 06.12.2016
(51) Int. Cl.: H03F 1/26, H03F 1/34, H03F 3/193, H03F 3/24

(54) **AMPLIFICATEUR DE PUISSANCE RADIO FREQUENCE A FAIBLE BRUIT ET SYSTEME D'EMISSION ET DE RECEPTION COMPORTANT UN TEL AMPLIFICATEUR**
STÖRUNGSARMER FUNKFREQUENZLEISTUNGSVERSTÄRKER, UND SYSTEM ZUM SENDEN UND EMPFANGEN, DAS EINEN SOLCHEN VERSTÄRKER UMFASST
LOW-NOISE RADIO FREQUENCY POWER AMPLIFIER AND TRANSMITTING AND RECEIVING SYSTEM COMPRISING SUCH AN AMPLIFIER

(30) Priorité: 09.12.2015 FR 1502560
(43) Date de publication de la demande: 14.06.2017
(73) Titulaire: Thales, 92400 Courbevoie (FR)
(72) Inventeur: GUERN, Pierre, 49300 CHOLET (FR); MAILLOUX, Pierre-Yves, 49300 CHOLET (FR); SABOUREAU, Cedrick, 49300 CHOLET (FR)
(74) Mandataire: Lucas, Laurent Jacques

(56) Documents cités:
- EP-A1- 2 506 443
- DE-A1- 3 529 078
- US-A1- 2003 214 357
- US-A1- 2005 270 104

## Description

La présente invention concerne un amplificateur de puissance RF dans lequel le bruit émis est fortement réduit. Elle concerne également un système d'émission et de réception RF comportant un tel amplificateur.

L'invention s'applique par exemple dans des systèmes d'émission et de réception RF co-localisés appartenant à des réseaux de télécommunication différents, où chaque système est susceptible de polluer l'autre.

Dans le domaine des télécommunications UHF ou VHF notamment, certaines missions imposent de placer en même endroit géographique des systèmes d'émission et de réception appartenant chacun à un réseau propre, les deux réseaux étant indépendants et fonctionnant à des fréquences proches. On dit que ces systèmes sont co-localisée, ou on parle encore de systèmes en co-site. C'est le cas notamment lorsque deux antennes, et leurs moyens d'émission et de réception associés, sont disposés sur un même véhicule. Il se produit alors un brouillage entre les deux systèmes et une dégradation de la portée. Plus particulièrement, dans une telle situation de proximité entre un émetteur d'un réseau et un récepteur d'un autre réseau, le récepteur est pollué par le bruit hors bande émis par l'émetteur. Les ordres de grandeur de puissance en jeu peuvent atteindre 5 Watts interceptés en réception pour 50 Watts émis par l'émetteur.

Dans les solutions connues pour résoudre ce problème de proximité géographique, le bruit d'émission est traité par filtrages multiples, consommateurs d'énergie et de volume dans les équipements, et sont par ailleurs coûteux.

Par ailleurs, les étages d'amplification de puissance, qui délivrent le signal à émettre, génèrent des bruits importants en pied de porteuse quand l'amplificateur travaille proche de sa saturation, et donc de son meilleur rendement. Ces bruits supplémentaires peuvent être considérables, bien supérieurs au bruit petit signal.

Enfin, le bruit du dernier étage de puissance peut ne pas pouvoir être filtré car la faisabilité de filtres très sélectifs n'est pas acquise à forte puissance. Même si ces filtres peuvent être réalisés, le rendement global de l'émetteur peut être considérablement réduit du fait des pertes dans ces filtres.

Des documents DE 35 29 078 A1, US 2005/270104 A1, US 2003/214357 A1 et EP 2 506 443 A1 divulguent des amplificateurs avec des circuits de contre-réaction.

Un but de l'invention est notamment de pallier les inconvénients précités. A cet effet, l'invention a pour objet un amplificateur de puissance RF tel que décrit par les revendications.

L'invention concerne également un système d'émission et de réception radio fréquences comportant un amplificateur de puissance tel que décrit précédemment.

D'autres avantages et caractéristiques de l'invention apparaîtront à l'aide de la description qui suit, faite en regard de dessins annexés qui représentent :
- La figure 1, un exemple d'amplificateur de puissance selon l'art antérieur ;
- La figure 2, une illustration de la génération du bruit d'un amplificateur de puissance RF transposé en pied de porteuse ;
- La figure 3, un exemple de réalisation d'un amplificateur de puissance selon l'invention ;
- La figure 4, une illustration de la correction de bruit apportée par l'invention ;
- La figure 5, une comparaison des bruits générés entre un amplificateur selon l'art antérieur et un amplificateur selon l'invention.

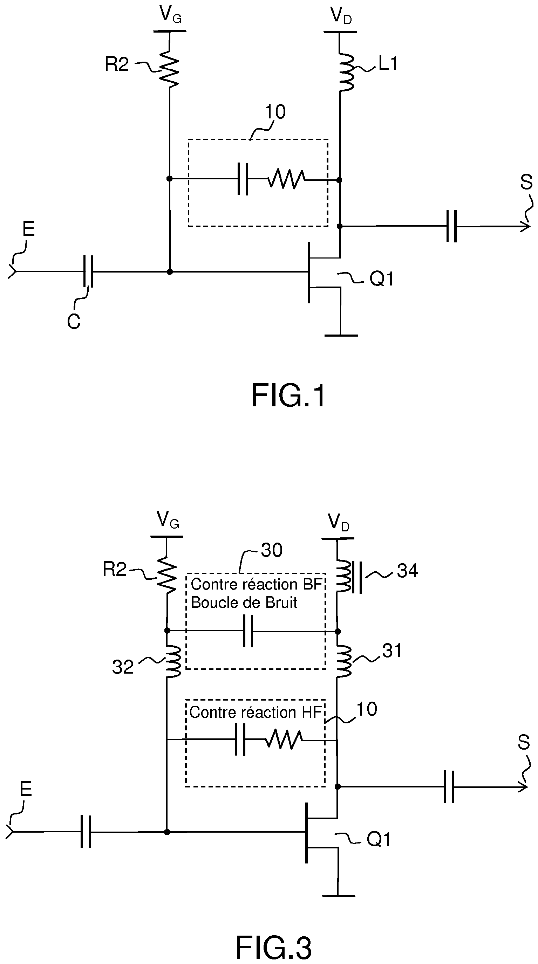

La figure 1 présente de façon schématique un amplificateur de puissance selon l'art antérieur. Celui comporte au moins un transistor Q1 destiné à amplifier un signal d'entrée E, bas niveau. On considère par la suite, à titre d'exemple, un transistor à effet de champ. En cas de besoin, plusieurs transistors peuvent être interconnectés en parallèle pour fournir la puissance nécessaire. Une puissance typique dans le domaine des télécommunications UHF ou VHF est 50 Watts. Le transistor est relié à deux tensions de polarisation V_{D} et V_{G}. La première, V_{D}, reliée au drain du transistor via une inductance L1 fournit la puissance électrique nécessaire à l'amplification. La seconde, V_{G}, polarise la tension de grille du transistor via une résistance R2. Classiquement une boucle de contre-réaction 10, active en UHF et VHF, est connectée entre le drain et la grille. Cette boucle de contre-réaction 10 détermine notamment le gain RF de l'étage d'amplification formé par le transistor. Les signaux radiofréquence présents sur l'entrée E de l'amplificateur sont couplés à la grille du transistor via une capacité C.

L'amplificateur génère un bruit qui est présent au niveau de l'antenne. Plus précisément, le bruit résultant au niveau de l'antenne est le bruit de sortie de l'amplificateur et plus particulièrement du transistor Q1.

Comme il a été indiqué précédemment, le filtrage du bruit en sortie de l'étage de puissance n'est pas toujours possible. En particulier, en VHF on sait filtrer en sortie du transistor Q1 mais pas en UHF.

Le bruit en sortie du transistor Q1 est composé de deux types de bruit :
- Un bruit classique, dit bruit thermique, fonction de la température et de répartition fréquentielle à peu près uniforme ;
- Un bruit non classique, dit bruit électronique, dû au fonctionnement des semi-conducteurs.

En particulier, le niveau de bruit en sortie d'un amplificateur de puissance à transistor augmente considérablement au voisinage de la saturation. Ce phénomène est particulièrement visible dans les montages à transistors en classe AB. Le facteur de bruit équivalent, proche de la porteuse, peut être dégradé de 20 dB par rapport au fonctionnement petit niveau. Les deux phénomènes présentés ci-dessous peuvent expliquer ce deuxième type de bruit, non classique :
- D'une part, pour les amplificateurs de classe AB, le courant augmente considérablement quand le transistor commence à s'auto-polariser. Le bruit de recombinaison des porteurs (bruit de grenaille, bruit en 1/f, f étant la fréquence, notamment) généré en bande de base se retrouve transposé en pied de porteuse par les non-linéarités. Le bruit en 1/f en pied de porteuse est proportionnel au courant consommé et donc à la puissance moyenne émise pour un amplificateur de classe AB ;
- D'autre part, un amplificateur proche de sa saturation devient non linéaire, et donc replie, détecte et transpose l'ensemble de sa bande de bruit thermique en bande de base, puis transpose à nouveau ce bruit en pied de porteuse.

Les essais et tests réalisés par la Déposante ont montré que ce bruit est essentiellement généré en sortie du transistor, sur la voie drain-source dans le cas d'un transistor à effet de champ. Ce bruit n'est pas corrélé au bruit thermique en entrée du transistor. Le modèle classique de la source de bruit en entrée d'un amplificateur de puissance ne peut donc pas être pris en compte pour résoudre le problème posé.

Avant d'exposer la solution apportée par l'invention, on illustre ci-après la création de ce bruit généré en sortie du transistor.

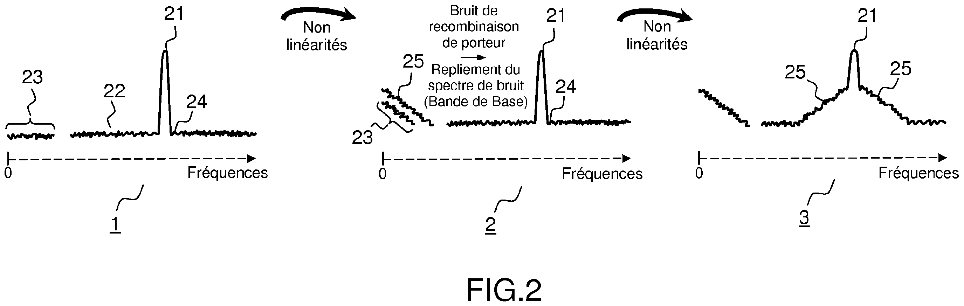

La figure 2 illustre les effets des non-linéarités tels que décrits précédemment, se produisant lorsque l'amplificateur est proche de la saturation, à son meilleur rendement.

Une première partie 1 montre, dans le domaine fréquentiel, la porteuse 21 du signal émis, qui se distingue du plancher de bruit thermique 22.

Une deuxième partie 2 montre le bruit de recombinaison des porteurs générés en bande de base 23, aux fréquences basses, ce bruit étant en 1/f. Les non-linéarités entraînent le repliement du spectre de bruit, en bande de base, comme l'illustre cette deuxième partie 2.

Une troisième partie 3 illustre la transposition du bruit généré en bande de base, en 1/f au pied 24 de la porteuse. Ce bruit ainsi transposé par les non-linéarités provoque un bruit 25 ajouté au pied de la porteuse 21 émis par l'amplificateur. Ce bruit, en 1/f, est proportionnel au courant consommé et donc à la puissance moyenne émise pour un amplificateur de classe AB. Comme indiqué précédemment, la Déposante a mis en évidence le fait que ce bruit est essentiellement généré en sortie du transistor Q1. Plus précisément, la grille du transistor reste non bruitée alors que la source comporte le bruit.

Le modèle classique de bruit d'un amplificateur de puissance prenant comme hypothèse une entrée bruitée n'est donc pas adapté pour contrer ce bruit.

La figure 3 illustre un exemple de réalisation d'un amplificateur selon l'invention. Pour supprimer le bruit 25 en pied de porteuse, ou au moins l'atténuer fortement, selon l'invention on ajoute une boucle analogique de contre-réaction 30 en bande de base. Cela revient, à basse fréquence, à asservir la sortie S de l'amplificateur sur l'entrée E, moins bruyante. En d'autres termes, cela revient à injecter une partie du bruit de sortie en entrée du transistor de façon à annuler ce bruit. La boucle de bruit est active dans la bande de base 23, par exemple entre quelques centaines de kilohertz et quelques mégahertz.

En reprenant l'exemple de réalisation de la figure 1, la boucle de contre-réaction 30, que l'on appellera par la suite boucle de bruit, est connectée parallèlement à la boucle de contre-réaction classique 10, en ajoutant quelques composants ou circuits d'adaptation.

En particulier, cette boucle de bruit 30 est reliée entre la sortie et l'entrée de l'amplificateur via des inductances de découplage 31, 32. Plus précisément, une première inductance 31 est connectée entre la boucle de bruit 30 et le drain du transistor Q1 et une deuxième inductance 32 est connectée entre la boucle de bruit 30 et la grille du transistor. Ces inductances sont passantes en basses fréquences, dans la bande de base correspondant aux fréquences à filtrer, et isolent la boucle de bruits en hautes fréquences.

En ce qui concerne la connexion aux tensions de polarisation VG, VD, la boucle de bruit est connectée d'un côté à la tension drain VD par un filtre basse fréquences et radiofréquences, par exemple une inductance 34. Elle est connectée de l'autre côté à la tension de grille VG via la résistance de polarisation R2, déjà présente sur le montage de la figure 3.

La boucle de bruit 30 est par exemple constituée d'un condensateur dont la valeur de capacité est adaptée aux fréquences de base. Plus précisément, la capacité est calculée de façon à ce que la boucle de bruit soit active dans les bandes d'intérêt, dans les basses fréquences, correspondant à la bande de fréquence autour de la porteuse dans laquelle on souhaite diminuer le bruit émis.

La boucle de contre-réaction 30 est en basse fréquence, quasiment en bande de base et donc en dessous de la bande utile d'amplification de l'amplificateur. La bande utile est la bande d'utilisation de l'amplificateur ou bande radiofréquences, entre une fréquence Fmin et une fréquence Fmax. Par exemple, Fmin = 20 MHz et Fmax = 500 MHz. La bande de base est la bande de modulation, ici la bande située en dessous de la bande utile, soit entre 0 et Fmin. Un effet de l'invention est d'obtenir un maximum de contre-réaction en dessous de la bande utile, en dessous de Fmin de l'amplificateur, tout en ne modifiant pas la contre-réaction et donc le gain de l'amplificateur dans sa bande utile, Fmin à Fmax.

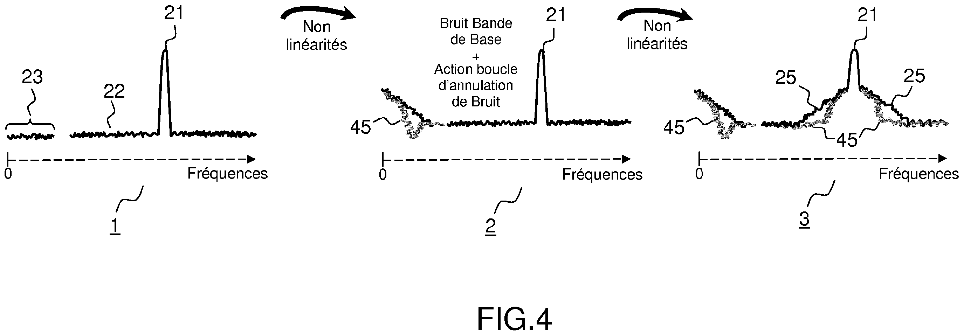

La figure 4 illustre les effets de la boucle de bruit sur l'atténuation du bruit en pied de porteuse.

La première partie 1 reprend, dans le domaine fréquentiel, le cas de la figure 2 avec la porteuse 21, le plancher de bruit thermique 22 et la bande de fréquence de base.

Les deux autres parties 2', 3' reprennent le spectre bruit 25 de bande de base de la figure 2 et le spectre du bruit 45 corrigé par la boucle de bruit 30. La deuxième partie 2' présente donc le bruit corrigé 45 avant transposition, avec une forte atténuation par rapport au bruit en 1/f non corrigé.

La troisième partie 3' illustre la transposition du bruit corrigé 45 en bande de base, au pied 24 de la porteuse. Le bruit corrigé étant fortement atténué, on retrouve cette atténuation au pied de la porteuse.

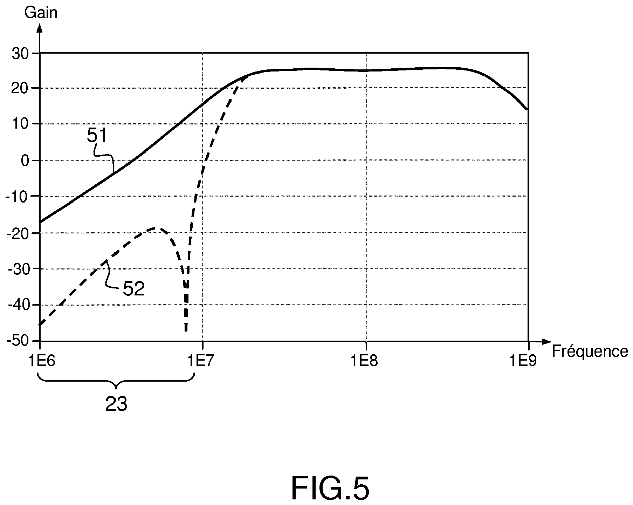

La figure 5 présente, sous une forme, l'atténuation obtenue sur le bruit généré en sortie du transistor Q1, vue de la sortie de l'amplificateur. Une première courbe 51 représente le gain du bruit en fonction de la fréquence sans boucle de bruit. Une deuxième courbe 52 représente le gain du bruit pour un amplificateur de puissance selon l'invention, équipé de la boucle de bruit 30. Cette deuxième courbe 52 montre une forte diminution du bruit dans la bande de base 23, diminution que l'on retrouve au pied de la porteuse 21 comme l'illustre la figure 4.

Les figures 4 et 5 montrent clairement que l'invention permet de limiter considérablement le bruit vu de la sortie de l'amplificateur de puissance. En pratique, cette réduction du bruit en bande de base se traduit par une diminution importante de la dégradation du bruit en pied de porteuse apporté par les non-linéarités et les bruits de recombinaison de porteur. La figure 4 montre notamment que le bruit résultant transposé en pied de porteuse se rapproche du bruit thermique classique. Les essais effectués par la Déposante ont montré que ces puissances de bruits 10 à 100 fois plus importantes sont mesurées en l'absence de la boucle de bruit 30.

Avantageusement, la présente invention peut être mise en oeuvre de façon très simple et économique. Il est en effet aisé et peu coûteux de mettre une boucle de contre-réaction basses fréquences en parallèle de la boucle de contre-réaction de gain classique. Dans une version simple, telle qu'illustrée par la figure 3, la contre réaction basses fréquences 30 est insérée au niveau des découplages R2, 34 de la polarisation du transistor.

L'invention a également pour avantage qu'elle est compacte, c'est-à-dire qu'elle n'augmente pas l'encombrement ou la surface occupée par l'amplificateur de puissance, ou de façon très limitée. Enfin, elle ne dégrade pas le rendement de l'amplificateur. Des essais réalisés par la Déposante, ont montré en particulier qu'on peut atteindre avec un amplificateur selon l'invention une réduction de bruit de l'ordre de 15 dB du bruit en pied de porteuse ajouté et émis par l'amplificateur, sans filtrage, sans pertes, et donc sans perte de rendement. Avantageusement, on peut dans certains cas d'application supprimer le filtre de sortie habituellement utilisé pour les applications en co-site.

## Revendications

1. Amplificateur de puissance RF comportant au moins un transistor (Q1) destiné à amplifier un signal d'entrée, dans une bande utile, ledit transistor comportant un premier circuit de contre-réaction (10) déterminant son gain d'amplification, **caractérisé en ce qu'**il comporte un deuxième circuit de contre-réaction (30) comportant un condensateur, ledit deuxième circuit (30) étant relié entre la sortie et l'entrée dudit transistors (Q1) via des inductances (31, 32), lesdites inductances formant un filtre avec ledit condensateur, ledit filtre étant :
- passant dans une bande de fréquences de base (23) dans laquelle du bruit (25) est produit en sortie dudit transistor, de sorte qu'une partie dudit bruit de sortie est injectée en entrée dudit transistor via ledit deuxième circuit, et ;
- isolant pour les autres fréquences la bande de fréquences de base étant en dessous de la bande utile.

2. Amplificateur de puissance selon la revendication 1, **caractérisé en ce que** ledit amplificateur émettant un signal ayant une porteuse donnée (21), une bande de fréquence autour de ladite porteuse (21), dans laquelle on souhaite diminuer ledit bruit émis (25), est une transposition de ladite bande de fréquences de base (23).

3. Amplificateur de puissance selon l'une quelconque des revendications précédentes, **caractérisé en ce que** ledit transistor (Q1) étant un transistor à effet de champ, ledit circuit de contre-réaction (30) est connecté au drain dudit transistor via une première inductance (31) et à la grille dudit transistor via une deuxième inductance (32).

4. Système d'émission et de réception radio fréquences, **caractérisé en ce qu'**il comporte un amplificateur de puissance (Q1, 10, 31, 32) selon l'une quelconque des revendications précédentes.

## Patentansprüche

1. HF-Leistungsverstärker, der mindestens einen Transistor (Q1) umfasst, zum Verstärken eines Eingangssignals in einem Nutzband,
wobei der Transistor einen ersten Rückkopplungsschaltkreis (10) umfasst, der seinen Verstärkungsfaktor bestimmt, **dadurch gekennzeichnet, dass** er einen zweiten Rückkopplungsschaltkreis (30) umfasst, der einen Kondensator umfasst, wobei der zweite Schaltkreis (30) über Induktoren (31, 32) zwischen den Ausgang und den Eingang des Transistors (Q1) geschaltet ist, wobei die Induktoren mit dem Kondensator ein Filter bilden, wobei das Filter:
- in einem Basisfrequenzband (23) durchlassend ist, in dem am Ausgang des Transistors Rauschen (25) erzeugt wird, so dass ein Teil des Ausgangsrauschens am Eingang des Transistors über den zweiten Schaltkreis injiziert wird, und;
- für die anderen Frequenzen isolierend ist, wobei das Basisfrequenzband unterhalb des Nutzbandes liegt.

2. Leistungsverstärker nach Anspruch 1, **dadurch gekennzeichnet, dass** der Signalemissionsverstärker mit einem gegebenen Träger (21), einem Frequenzband um den Träger (21), in dem das übertragene Rauschen (25) verringert werden soll, eine Transposition des Basisfrequenzbandes (23) ist.

3. Leistungsverstärker nach einem der vorhergehenden Ansprüche, **dadurch gekennzeichnet, dass** der Transistor (Q1) ein Feldeffekttransistor ist und der Rückkopplungsschaltkreis (30) über einen ersten Induktor (31) mit dem Drainbereich des Transistors und über einen zweiten Induktor (32) mit dem Gate des Transistors verbunden ist.

4. Hochfrequenz-Sende- und Empfangssystem, **dadurch gekennzeichnet, dass** es einen Leistungsverstärker (Q1, 10, 31, 32) nach einem der vorhergehenden Ansprüche umfasst.

## Claims

1. RF power amplifier comprising at least one transistor (Q1) for amplifying an input signal in a useful band,
said transistor having a first feedback circuit (10) determining its amplification gain, **characterized in that** it comprises a second feedback circuit (30) including a capacitor, said second circuit (30) being connected between the output and the input of said transistor (Q1) via inductors (31, 32), said inductors forming a filter with said capacitor, said filter being:
- transmitting in a base frequency band (23), in which noise (25) is produced at the output of said transistor, so that a portion of said output noise is injected at the input of said transistor via said second circuit, and;
- isolating for the other frequencies, the base frequency band being below the useful band.

2. Power amplifier according to claim 1, **characterized in that** said amplifier emitting a signal having a given carrier (21), a frequency band around said carrier (21), wherein it is desired to reduce the emitted noise (25), is a transposition of said base frequency band (23).

3. Power amplifier according to any one of the preceding claims, **characterized in that** said transistor (Q1) being a field effect transistor, said feedback circuit (30) is connected to the drain of said transistor via a first inductance (31) and to the gate of said transistor via a second inductance (32).

4. System for transmitting and receiving radio frequencies, **characterized in that** it comprises a power amplifier (Q1, 10, 31, 32) according to any one of the preceding claims.
